# EUROPEAN PATENT APPLICATION

(11) **EP 3 565 123 A1**
(43) Date of publication of application: **06.11.2019**
(21) Application number: 18170512.0
(22) Date of filing: 03.05.2018
(51) Int. Cl.: H03M 3/00, H03M 1/12, H03M 1/60

(54) **CONTINUOUS TIME SIGMA DELTA MODULATOR, METHOD OF OPERATING A CONTINUOUS TIME SIGMA DELTA MODULATOR AND ANALOG-TO-DIGITAL CONVERTER**

(71) Applicant: Intel IP Corporation, Santa Clara, CA 95054 (US)
(72) Inventor: DI GIANDOMENICO, Antonio, 9524 Villach (AT); PATON-ALVAREZ, Susana, 28911 Leganes Madrid (ES); FERNANDEZ-GUTIERREZ, Eric, 28911 Leganes Madrid (ES); HERNANDEZ-CORPORALES, Luis, 28039 Madrid (ES)
(74) Representative: 2SPL Patentanwälte PartG mbB

(57) **Abstract**

A continuous time sigma delta modulator is provided. The modulator includes a ring oscillator configured to generate, based on an analog oscillator control signal, a plurality of phase shifted oscillation signals. Further, the modulator includes a plurality of sample circuits configured to generate a plurality of sampled signals by sampling each of the plurality of oscillation signals based on each of a plurality of phase shifted reference signals. The modulator additionally includes a digital-to-analog converter configured to generate an analog feedback signal based on the plurality of sampled signals. The oscillator control signal is based on the feedback signal.

## Description

### Field

Examples relate to a Continuous Time Sigma Delta Modulator (CTSDM) and a method of operating a CTSDM. Further examples relate to an Analog-to-Digital Converter (ADC) using the CTSDM.

### Background

Conventional CTSDMs for high bandwidth signals use, e.g., time-interleaved flash quantizers and multibit Digital-to-Analog Converters (DACs) to achieve desired sampling rates (e.g. for oversampling a high bandwidth signal). However, flash quantizers require a rather large die area, and stabilizing the sigma delta loop is quite difficult.

Hence, there may be a desire for an improved CTSDM architecture.

### Brief description of the Figures

Some examples of apparatuses and/or methods will be described in the following by way of example only, and with reference to the accompanying figures, in which
Fig. 1 illustrates a first example of a CTSDM;
Fig. 2 illustrates a second example of a CTSDM;
Fig. 3 illustrates enlarged a detail of the CTSDM illustrated in Fig. 2;
Fig. 4 illustrates a third example of a CTSDM;
Fig. 5 illustrates a fourth example of a CTSDM;
Fig. 6 illustrates an example of an ADC using a CTSDM; and
Fig. 7 illustrates a flowchart of an example of a method of operating a CTSDM.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Same or like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e. only A, only B as well as A and B, if not explicitly or implicitly defined otherwise. An alternative wording for the same combinations is "at least one of A and B" or "A and/or B". The same applies, mutatis mutandis, for combinations of more than two Elements.

The terminology used herein for the purpose of describing particular examples is not intended to be limiting for further examples. Whenever a singular form such as "a", "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises", "comprising", "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

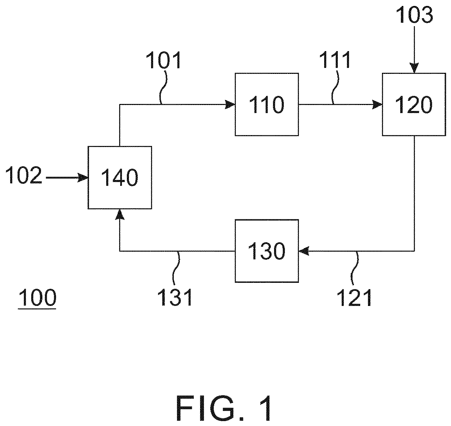

Fig. 1 illustrates an example of a CTSDM 100. CTSDM 100 comprises a ring oscillator 110 configured to generate, based on an analog oscillator control signal 101, a plurality of oscillation signals 111. For example, ring oscillator 110 may generate M oscillation signals, wherein M ≥ 2. The plurality of oscillation signals 111 are phase shifted with respect to each other. For example, the phase shift between oscillation signals exhibiting consecutive phases may be the same for all of the plurality of oscillation signals 111.

Further, CTSDM 100 comprises a plurality of sample circuits 120 configured to generate a plurality of sampled signals 121. The plurality of sample circuits 120 are configured to sample each of the plurality of oscillation signals 111 based on each of a plurality of reference signals 103. The plurality of reference signals 103 are phase shifted with respect to each other. For example, the phase shift between reference signals exhibiting consecutive phases may be the same for all of the plurality of reference signals 103. The plurality of reference signals 103 may, e.g., be oscillation signals. A frequency f_{osc} of the plurality of oscillation signals 111 may be equal to a frequency f_{ref} of the plurality of reference signals 103. For example, the plurality of reference signals 103 may comprise N reference signals, wherein N ≥ 2. Accordingly, the plurality of sample circuits 120 may comprise N · M sample circuits 120, which generate N · M sampled signals.

CTSDM 100 additionally comprises a DAC 130 configured to generate an analog feedback signal 131 based on the plurality of sampled signals 121. The oscillator control signal 101 is based on the feedback signal 131. For example, a loop filter 140 may be coupled between DAC 130 and ring oscillator 110, wherein loop filter 140 is configured to generate the oscillator control signal 101 based on the feedback signal 131 and an analog input signal 102 for CTSDM 100.

CTSDM 100 provides a time interleaved architecture using polyphase ring oscillator 110. By sampling the plurality of phase shifted oscillation signals 111 based on the plurality of phase shifted reference signals 103, the ring oscillator 110 output may be sampled with a (very) high resolution in time. Accordingly, the analog input signal 102 may be sampled with a high sample rate. A time interleaved multibit signal may be generated (e.g. as an output signal of CTSDM 100) based on the plurality of sampled signals 121, so that an effective sample rate of CTSDM 100 may be N . f_{ref}.

Compared to conventional CTSDMs, CTSDM 100 may allow to use mostly digital circuitry since a simpler ring oscillator 110 is used instead of the commonly used flash comparators, references and pre-amplifiers. Accordingly, a power consumption as well as a number of used transistors may be reduced for CTSDM 100 compared to conventional CTSDMs.

Further, CTSDM 100 may allow to increase the sample rate compared to conventional CTSDMs and allow sufficient oversampling rates for analog input signal 102 exhibiting high bandwidth (e.g. more than 100 MHz).

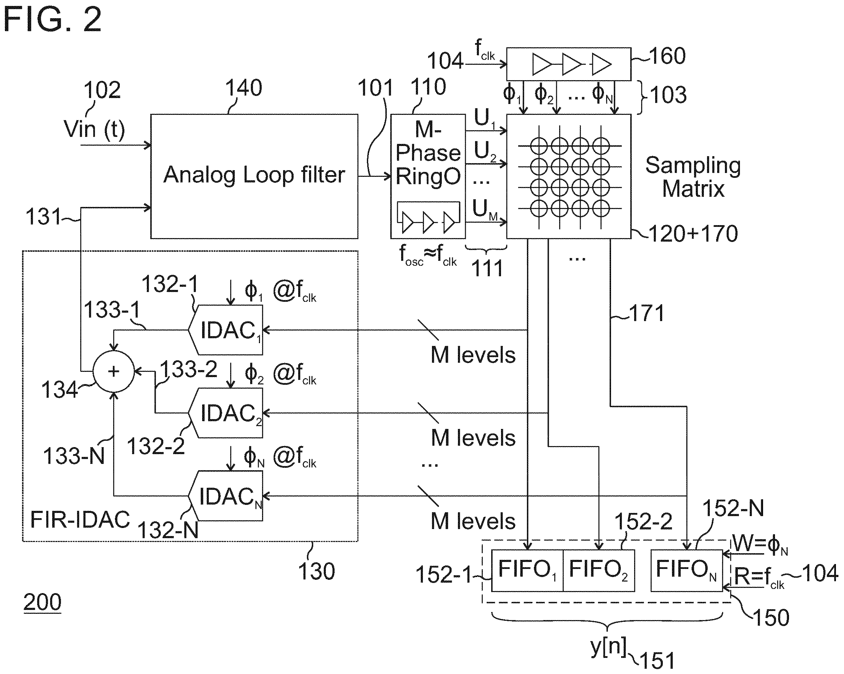

While some basic principles of the proposed architecture are explained above in connection with Fig. 1, some further examples of CTSDMs according to the proposed architecture are illustrated with more details in Figs. 2 to 5.

**Fig. 2** illustrates a CTSDM 200 comprising a ring oscillator 110 configured to generate, based on an analog oscillator control signal 101, M ≥ 2 phase shifted oscillation signals (i.e. a plurality of oscillation signals 111). The plurality of oscillation signals 111 exhibit a frequency f_{osc}.

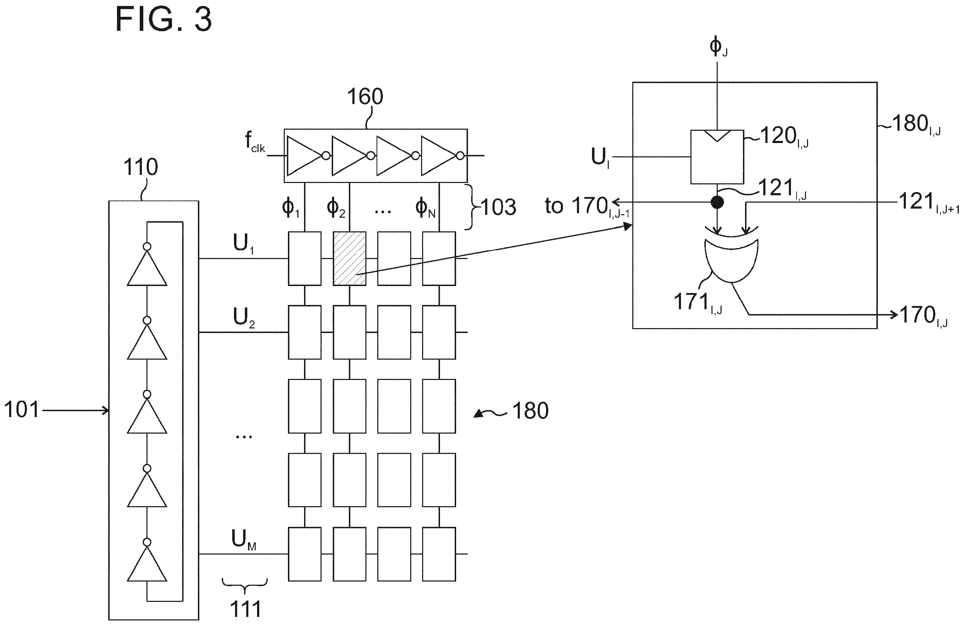

The plurality of oscillation signals 111 are sampled by means of a plurality of sample circuits 120. The generated sampled signals 121 are further logically combined using a plurality of logic circuits 170. This is illustrated with more details in **Fig. 3****.**

The plurality of logic circuits 170 are coupled between the plurality of sample circuits 120 and DAC 130 of CTSDM 200. For example, the plurality of logic circuits 170 and the plurality of sample circuits 120 may be arranged in a matrix, wherein each of the plurality of logic circuits 170 is grouped with one of the plurality of sample circuits 120. Each pair of logic circuit and sample circuit may be understood as a sample cell. Accordingly, the plurality of logic circuits 170 and the plurality of sample circuits 120 may form a matrix (an array) of sample cells 180 as illustrated in Fig. 3. One exemplary sample cell 180_{I,J} comprising a sample circuit 120_{I,J} of the plurality of sample circuits 120 and a logic circuit 170_{I,J} of the plurality of logic circuits 170 is illustrated with more details in Fig. 3.

Sample circuit 120_{I,J} receives a reference signal Φ_{J} of the plurality of reference signals 103 and an oscillation signal U_{I} of the plurality of oscillation signals 111. The plurality of reference signals 103 are oscillation signals generated, based on a reference clock signal 104 exhibiting a frequency f_{clk}, by a digital delay line 160 comprising a plurality of delay circuits. Alternatively, the plurality of reference signals 103 may, e.g., be generated using a second ring oscillator instead of digital delay line 160.

Sample circuit 120_{I,J} samples oscillation signal U_{I} based on reference signal Φ_{J} in order to generate sampled signal 121_{I,J} of the plurality of sampled signals 121. For example, sample circuit 120_{I,J} may be flip-flop (latch) circuit.

The sampled signal 121_{I,J} is received by logic circuit 170_{I,J} together with another sampled signal of the plurality of sampled signals 121. The other sampled signal of the plurality of sampled signals 121 is based on the same oscillation signal U_{I} of the plurality of oscillation signals 111 as sampled signal 121_{I,J}, but is based on a different reference signal of the plurality of reference signals 103 than sampled signal 121_{I,J}.

In CTSDM 200, the sampled signal 121_{I,J} and the other sampled signal of the plurality of sampled signals 121 are based on reference signals of the plurality of reference signals 103 that exhibit consecutive phases among the plurality of reference signals. As indicated in Fig. 3, the other sampled signal may be sampled signal 121_{I,J+1} which is based on reference signal Φ_{J+1} of the plurality of reference signals 103. Sampled signal 121_{I,J+1} is received from sample circuit 120_{I,J+1} of sample cell 180_{I,J+1} (not illustrated). Similarly, sampled signal 121_{I,J} is supplied to logic circuit 170_{I,J-1} of sample cell 180_{I,J-1} (not illustrated). Alternatively, the other sampled signal may be sampled signal 121_{I,J-1} which is based on reference signal Φ_{J-1} of the plurality of reference signals 103. Sampled signal 121_{I,J-1} is received from sample circuit 120_{I,J-1} of sample cell 180_{I,J-1}. Accordingly, sampled signal 121_{I,J} is supplied to logic circuit 170_{I,J+1} of sample cell 180_{I,J+1}.

Logic circuit 170_{I,J} is configured to generate a logic signal 171_{I,J} based on the two input sampled signals. In CTSDM 200, logic circuit 170_{I,J} is configured to generate logic signal 171_{I,J} based on a logical XOR combination of the two sampled signals.

Similarly to sample circuit 120_{I,J}, the other sample circuits of the plurality of sample circuits 120 generate the other (N · M) - 1 sampled signals of the plurality of sampled signals 121. Accordingly, the other logic circuits of the plurality of logic circuits 170 generate the other (N · M) - 1 logic signals of the plurality of logic signals 171.

Referring back to Fig. 2, DAC 130 is configured to generate an analog feedback signal 131 based on logic signal 171_{I,J} and the other logic signals of the plurality of logic signals 171. A loop filter 140 is coupled between DAC 130 and ring oscillator 110, and configured to generate the oscillator control signal 101 based on feedback signal 131 and an analog input signal 102 for CTSDM 200.

DAC 130 comprises a plurality of digital-to-analog conversion circuits 132-1, 132-2, ..., 132-N for generating contributions to the feedback signal 131 based on different subsets of the plurality of logic signals 171. The number of digital-to-analog conversion circuits is equal to the number N of the plurality of reference signals 103. The operation of the plurality of digital-to-analog conversion circuits 132-1, 132-2, ..., 132-N is exemplarily explained by means of first digital-to-analog conversion circuit 132-1 and second digital-to-analog conversion circuit 132-2.

The first digital-to-analog conversion circuit 132-1 is configured to generate a first contribution 133-1 to the feedback signal 131 based on a first subset of the plurality of logic signals 171. The logic signals of the first subset of the plurality of logic signals 171 are based on sampled signals of the plurality of sampled signals 121 that are based on a first pair of reference signals Φ₁ and Φ₂ of the plurality of reference signals 103. For example, a first logic signal of the first subset of the plurality of logic signals 171 is based on the logical combination of the sampled signals 121_{I,1} and 121_{I,2}, and a second logic signal of the first subset of the plurality of logic signals 171 is based on the logical combination of the sampled signals 121_{I+1,1} and 121_{I+1,2}. Accordingly, the other logic signals of the first subset of the plurality of logic signals 171 may be based on the first pair of reference signals Φ₁ and Φ₂ of the plurality of reference signals 103 and the other oscillation signals of the plurality of oscillation signals. As a consequence, the number of logic signals in the first subset of the plurality of logic signals 171 is equal to the number M of the plurality of oscillation signals 111.

A second digital-to-analog conversion circuit 132-2 is configured to generate a second contribution 133-2 to the feedback signal 131 based on a second subset of the plurality of logic signals 171. The logic signals of the second subset of the plurality of logic signals 171 are based on sampled signals of the plurality of sampled signals 121 that are based on a second pair of reference signals Φ₂ and Φ₃ of the plurality of reference signals 103. For example, a first logic signal of the second subset of the plurality of logic signals 171 is based on the logical combination of the sampled signals 121_{I,2} and 121_{I,3}, and a second logic signal of the second subset of the plurality of logic signals 171 is based on the logical combination of the sampled signals 121_{I+1,2} and 121_{I+1,3}. Accordingly, the other logic signals of the second subset of the plurality of logic signals 171 may be based on the second pair of reference signals Φ₂ and Φ₃ of the plurality of reference signals 103 and the other oscillation signals of the plurality of oscillation signals. As a consequence, the number of logic signals in the second subset of the plurality of logic signals 171 is equal to the number M of the plurality of oscillation signals 111.

The first digital-to-analog conversion circuit 132-1 is clocked by reference signal Φ₁ of the plurality of reference signals 103, whereas the second digital-to-analog conversion circuit 132-2 is clocked by reference signal Φ₂ of the plurality of reference signals 103. In other words, the first digital-to-analog conversion circuit 132-1 is clocked based on one of the first pair of reference signals Φ₁ and Φ₂, and the second digital-to-analog conversion circuit 132-2 is clocked based on one of the second pair of reference signals Φ₂ and Φ₃.

The other digital-to-analog conversion circuits of DAC 130 are operated in the same way.

A signal combiner 134 of DAC 130 is configured to generate the feedback signal 131 based on the contributions 133-1, 133-2, ..., 133-N of the plurality of digital-to-analog conversion circuits 132-1, 132-2, ..., 132-N. That is, the signal combiner 134 of DAC 130 is configured to generate the feedback signal 131 based on at least the first contribution 132-1 and the second contribution 132-1.

Further, CTSDM 200 comprises an output circuit 150 configured to generate a digital output signal 151 based on the plurality of logic signals 171. Output circuit 150 comprises a plurality of First-In First-Out (FIFO) memory circuit 152-1, 152-2, ..., 152-N. The number of FIFO memory circuits is equal to the number N of the plurality of reference signals 103. The operation of the plurality of FIFO memory circuits 152-1, 152-2, ..., 152-N is exemplarily explained by means of first FIFO memory circuit 152-1 and second FIFO memory circuit 152-2.

First FIFO memory circuit 152-1 is configured to store logic values of the first subset of the plurality of logic signals 171 based on a first clock signal, whereas the second FIFO memory circuit 152-2 is configured to store logic values of the second subset of the plurality of logic signals 171 based on a second clock signal. The first clock signal is reference signal Φ₁ of the plurality of reference signals 103, and the second clock signal is reference signal Φ₂ of the plurality of reference signals 103. That is, the first clock signal is on one of the first pair of reference signals Φ₁ and Φ₂, whereas the second clock signal is on one of the second pair of reference signals Φ₂ and Φ₃. The first FIFO memory circuit 152-1 and the second FIFO memory circuit 152-2 are configured to output the oldest memory value as digital output signal 151 based on the same clock signal, respectively. The clock signal is reference clock signal 104. In other words, the first FIFO memory circuit 152-1 and the second FIFO memory circuit 152-2 are asynchronous FIFO memory circuits.

The other FIFO memory circuits of output circuit 150 are operated in the same way. That is, the plurality of FIFO memory circuits 152-1, 152-2, ..., 152-N are read sequentially based on reference clock signal 104 in order to generate output signal 151.

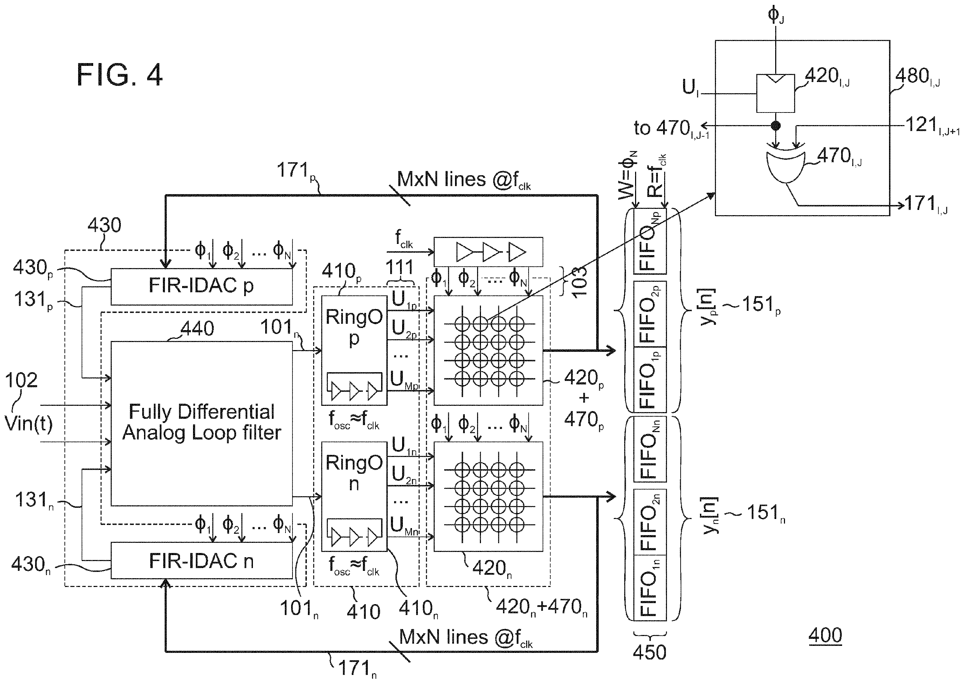

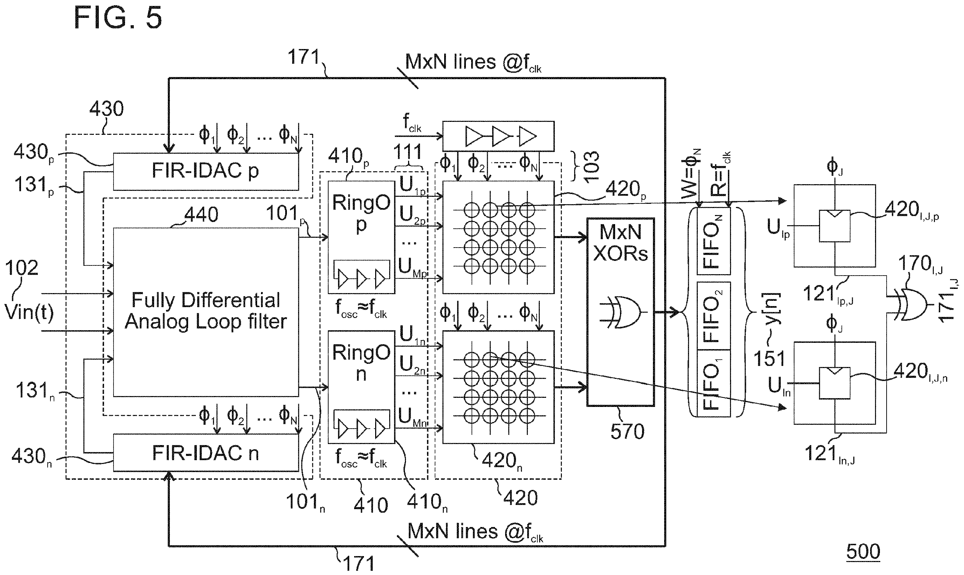

While Figs. 2 and 3 illustrate a single ended implementation of a CTSDM according to the proposed architecture. Figs. 4 and 5 illustrated to two differential implementations of CTSDMs according to the proposed architecture. In order to avoid lengthy repetitions, the description of Figs. 4 and 5 mainly focusses on the differences of the illustrated CTSDMs with respect to CTSDM 200.

**Fig. 4** illustrates CTSDM 400 exhibiting a pseudodifferential architecture with phase decoding. CTSDM 400 comprises a ring oscillator 410 configured to generate a first part of the plurality of phase shifted oscillation signals 111 with a first polarity and a second part of the plurality of phase shifted oscillation signals 111 with a different second polarity. As indicated in Fig. 4, ring oscillator 410 may, e.g., comprise first ring oscillator circuitry 410ₚ for generating the first part of the plurality of oscillation signals 111 and second ring oscillator circuitry 410ₙ for generating the second part of the plurality of oscillation signals 111. The first part of the plurality of oscillation signals 111 comprises M phase shifted oscillation signals U₁ₚ, ..., U_{Mp} of the first polarity, and the second part of the plurality of oscillation signals 111 comprises M phase shifted oscillation signals U₁ₙ, ..., U_{Mn} of the second polarity.

Further, CTSDM 400 comprises a plurality of sample circuits 420 configured to generate a plurality of sampled signals 121. The plurality of sample circuits 420 are configured to sample each of the plurality of oscillation signals 111 based on each of a plurality of phase shifted reference signals 103. The plurality of phase shifted reference signals 103 comprises N phase shifted reference signals Φ₁ to Φ_{N}. As indicated in Fig. 4, the plurality of sample circuits 420 may, e.g., comprise a first subset of sample circuits 420ₚ for sampling each of the first part of the plurality of oscillation signals 111 based on each of the plurality of phase shifted reference signals 103, and a second subset of sample circuits 420ₙ for sampling each of the second part of the plurality of oscillation signals 111 based on each of the plurality of phase shifted reference signals 103. Accordingly, the plurality of sample circuits 420 may generate N · M sampled signals of the first polarity and N · M sampled signals of the second polarity.

The generated sampled signals 121 are further logically combined using a plurality of logic circuits 470 in order to generate a plurality of logic signals 171. As described above for CTSDM 200, the plurality of logic circuits 470 and the plurality of sample circuits 420 may be combined to sample cells and be arranged in a matrix. An exemplary sample cell 480_{I,J} comprising a sample circuit 420_{I,J} of the plurality of sample circuits 420 and a logic circuit 470_{I,J} of the plurality of logic circuits 470 is illustrated in Fig. 4. The function of sample cell 480_{I,J} is identical to the above described sample cell 180_{I,J}.

Accordingly, the plurality of logic circuits 470 generate N · M logic signals 171ₚ of the first polarity and N · M logic signals 171ₙ of the second polarity.

A DAC 430 is configured to generate an analog feedback signal based on the plurality of logic signals. The DAC 430 is configured to generate the feedback signal with a first feedback signal component 131ₚ of the first polarity based on the logic signals 171ₚ of the first polarity, and a second feedback signal component 131ₙ of the second polarity based on the logic signals 171ₙ of the second polarity. As indicated in Fig. 4, DAC 430 may, e.g., comprise a first DAC circuitry 430ₚ for generating the first feedback signal component 131ₚ and a second DAC circuitry 430ₙ for generating the second feedback signal component 131ₙ. The first DAC circuitry 430ₚ and the second DAC circuitry 430ₙ may both comprise a plurality of digital-to-analog conversion circuits and operate as described above in connection with Fig. 2.

A differential loop filter 440 is coupled between DAC 430 and ring oscillator 410, and configured to generate the oscillator control signal for ring oscillator 410 based on the feedback signal and a differential analog input signal 102 for CTSDM 400. For example, loop filter 440 may generate a first oscillator control signal component 101ₚ for first ring oscillator circuitry 410ₚ based on first feedback signal component 131ₚ of the first polarity and a signal component of analog input signal 102 of the first polarity, and a second oscillator control signal component 101ₙ for second ring oscillator circuitry 410ₙ based on second feedback signal component 131ₙ of the second polarity and a signal component of analog input signal 102 of the second polarity.

Output circuit 450 of CTSDM 400 generates a differential output signal based on the plurality of logic signals. As indicated in Fig. 4, output circuit 450 generates an output signal component 151ₚ of the first polarity based on the logic signals 171ₚ of the first polarity, and an output signal component 151ₙ of the second polarity based on the logic signals 171ₙ of the second polarity. The generation the output signal components of the different polarities is as described above for output circuit 150 of CTSDM 200.

Fig. 5 illustrates another CTSDM 500 exhibiting a fully differential architecture. Compared to CTSDM 400, the logic signals are generated in a different manner.

CTSDM 500 comprises a plurality of sample circuits 420 configured to generate a plurality of sampled signals 121. As described above in connection with Fig. 4, the plurality of sample circuits 420 generate N · M (i.e. a plurality of) sampled signals of the first polarity and N · M (i.e. a plurality of) sampled signals of the second polarity. This exemplarily illustrated by means of sample circuits 420_{I,J,p} and 420_{I,J,n} of the plurality of sample circuits 420.

Sample circuit 420_{I,J,p} receives a reference signal Φ_{J} of the plurality of reference signals 103 and an oscillation signal U_{Ip} of the plurality of oscillation signals 111 exhibiting the first polarity. Sample circuit 420_{I,J,p} receives the same reference signal Φ_{J} of the plurality of reference signals 103 and an oscillation signal U_{In} of the plurality of oscillation signals 111 exhibiting the second polarity. The two oscillation signals U_{Ip} and U_{In} of the plurality of oscillation signals 111 exhibit the same phase but different polarity.

Sample circuit 420_{I,J,p} samples oscillation signal U_{Ip} based on reference signal Φ_{J} in order to generate sampled signal 121_{Ip,J} of the plurality of sampled signals 121. Sample circuit 420_{I,J,n} samples oscillation signal U_{In} based on reference signal Φ_{J} in order to generate sampled signal 121_{In,J} of the plurality of sampled signals 121. That is, the two sampled signals 121_{Ip,J} and 121_{In,J} of the plurality of sampled signals are based on the same reference signal Φ_{J} of the plurality of reference signals 103.

Logic circuit 570_{I,J} is configured to generate a logic signal 171_{I,J} based on the two sampled signals 121_{Ip,J} and 121_{In,J}. In CTSDM 500, logic circuit 170_{I,J} is configured to generate logic signal 171_{I,J} based on a logical XOR combination of the two sampled signals 121_{Ip,J} and 121_{In,J}.

Similarly to sample circuit 420_{I,J,p}, the other sample circuits of the first subset of sample circuits 420ₚ generate the other (N . M) - 1 sampled signals of the plurality of sampled signals 121 exhibiting the first polarity. Similarly to sample circuit 420_{I,J,n}, the other sample circuits of the second subset of sample circuits 420ₙ generate the other (N · M) - 1 sampled signals of the plurality of sampled signals 121 exhibiting the second polarity. Accordingly, the other logic circuits of the plurality of logic circuits 570 generate the other (N · M) - 1 logic signals of the plurality of logic signals 171 by logically combining the sampled signals that are based on the same reference signal of the plurality of reference signals 103 and are based on two oscillation signals of the plurality of oscillation signals 111 exhibiting the same phase but different polarity.

DAC 430 is configured to generate, based on the plurality of logic signals 171, an analog feedback signal with a first feedback signal component 131ₚ of the first polarity and a second feedback signal component 131ₙ of the second polarity.

Further, output circuit 550 of CTSDM 500 is configured to generate a digital output signal 151 based on the plurality of logic signals 171. The operation of output circuit 550 is identical to the above described output circuit 150.

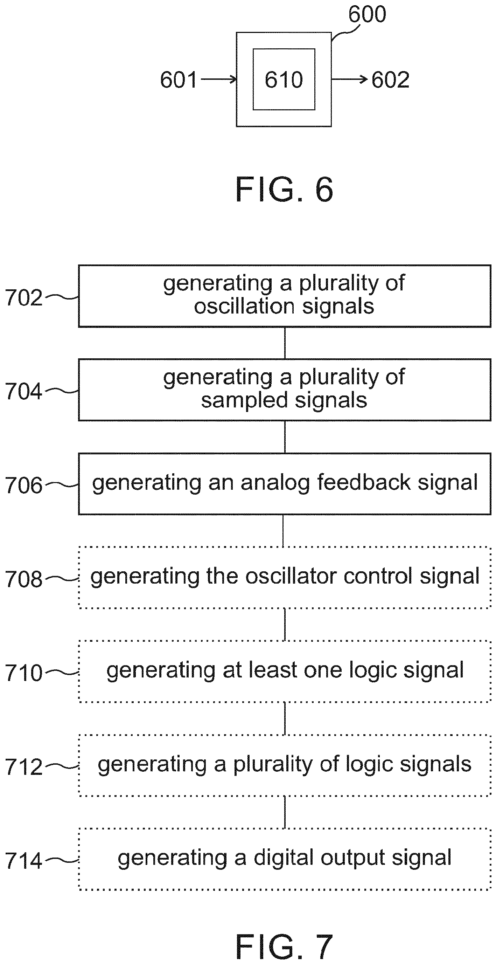

An example of an implementation using continuous time sigma delta modulation according to one or more aspects of the proposed architecture or one or more examples described above is illustrated in **Fig. 6.** Fig. 6 illustrates an example of an ADC 600 comprising a CTSDM 610 according to an example described herein. Using CTSDM 610 may allow to sample (e.g. oversample) an analog signal 601 of high bandwidth (e.g. more than 100 MHz bandwidth) with reduced power consumption compared to ADCs using conventional CTSDMs. Due to using a simpler ring oscillator for CTSDM 610 instead of flash comparators, references and power amplifiers as in conventional CTSDMs, a transistor count of CTSDM 610 may further be reduced compared to conventional CTSDMs. For example, ADC 600 may allow medium resolution analog-to-digital conversion of high bandwidth analog signal 601 to a digital signal 602 with (significantly) reduced power consumption.

An example of a method 700 of operating a CTSDM is illustrated by means of a flowchart in **Fig. 7****.** Method 700 comprises generating 702, based on an analog oscillator control signal, a plurality of phase shifted oscillation signals using a ring oscillator. Further, method 700 comprises generating 704, using a plurality of sample circuits, a plurality of sampled signals by sampling each of the plurality of phase shifted oscillation signals based on each of a plurality of phase shifted reference signals. Method 700 additionally comprises generating 706, using a DAC, an analog feedback signal based on the plurality of sampled signals. The oscillator control signal is based on the feedback signal.

Optionally, method 700 may comprise generating 708 the oscillator control signal based on the feedback signal and an analog input signal using a loop filter coupled between the DAC and the ring oscillator.

Method 700 may further comprise generating 710 at least one logic signal based on two sampled signals of the plurality of sampled signals using a plurality of logic circuits coupled between the plurality of sample circuits and the digital-to-analog converter. Generating 706 the analog feedback signal may accordingly comprise generating the analog feedback signal based on the least one logic signal.

Further optionally, method 700 may comprise generating 712 a plurality of logic signals using the plurality of logic circuits and generating 714 a digital output signal based on the plurality of logic signals using an output circuit.

More details and aspects of the method are mentioned in connection with the proposed technique or one or more examples described above (e.g. Figs. 1 to 5). The method may comprise one or more additional optional features corresponding to one or more aspects of the proposed technique or one or more examples described above.

The examples as described herein may be summarized as follows:
Example 1 is a continuous time sigma delta modulator, comprising: a ring oscillator configured to generate, based on an analog oscillator control signal, a plurality of phase shifted oscillation signals; a plurality of sample circuits configured to generate a plurality of sampled signals by sampling each of the plurality of oscillation signals based on each of a plurality of phase shifted reference signals; and a digital-to-analog converter configured to generate an analog feedback signal based on the plurality of sampled signals, wherein the oscillator control signal is based on the feedback signal.
Example 2 is the continuous time sigma delta modulator of example 1, further comprising a loop filter coupled between the digital-to-analog converter and the ring oscillator, wherein the loop filter is configured to generate the oscillator control signal based on the feedback signal and an analog input signal.
Example 3 is the continuous time sigma delta modulator of example 1 or example 2, further comprising a plurality of logic circuits coupled between the plurality of sample circuits and the digital-to-analog converter, wherein at least one of the plurality of logic circuits is configured to generate a logic signal based on two sampled signals of the plurality of sampled signals, wherein the digital-to-analog converter is configured to generate the analog feedback signal based on the logic signal.
Example 4 is the continuous time sigma delta modulator of example 3, wherein the least one of the plurality of logic circuits is configured to generate the logic signal based on a logical XOR combination of the two sampled signals.
Example 5 is the continuous time sigma delta modulator of example 3 or example 4, wherein the two sampled signals are based on the same oscillation signal of the plurality of oscillation signals and are based on different reference signals of the plurality of reference signals.
Example 6 is the continuous time sigma delta modulator of example 5, wherein the different reference signals of the plurality of reference signals exhibit consecutive phases among the plurality of reference signals.
Example 7 is the continuous time sigma delta modulator of any of examples 3 to 6, wherein the plurality of logic circuits are configured to generate a plurality of logic signals, and wherein the digital-to-analog converter comprises: a first digital-to-analog conversion circuit configured to generate a first contribution to the feedback signal based on a first subset of the plurality of logic signals, wherein the logic signals of the first subset of the plurality of logic signals are based on sampled signals of the plurality of sampled signals that are based on a first pair of reference signals of the plurality of reference signals; a second digital-to-analog conversion circuit configured to generate a second contribution to the feedback signal based on a second subset of the plurality of logic signals, wherein the logic signals of the second subset of the plurality of logic signals are based on sampled signals of the plurality of sampled signals that are based on a second pair of reference signals of the plurality of reference signals; a signal combiner configured to generate the feedback signal based on at least the first contribution and the second contribution.
Example 8 is the continuous time sigma delta modulator of example 7, wherein the first digital-to-analog conversion circuit is clocked based on one of the first pair of reference signals, and wherein the second digital-to-analog conversion circuit is clocked based on one of the second pair of reference signals.
Example 9 is the continuous time sigma delta modulator of example 7 or example 8, wherein the number of logic signals in the first subset of the plurality of logic signals is equal to the number of the plurality of oscillation signals.
Example 10 is the continuous time sigma delta modulator of any of examples 7 to 9, wherein the digital-to-analog converter comprises a number of digital-to-analog conversion circuits equal to the number of the plurality of reference signals.
Example 11 is the continuous time sigma delta modulator of any of examples 3 to 10, wherein the ring oscillator is configured to generate a first part of the plurality of oscillation signals with a first polarity and a second part of the plurality of oscillation signals with a second polarity, and wherein the digital-to-analog converter is configured to generate the feedback signal with a first feedback signal component of the first polarity and a second feedback signal component of the second polarity.
Example 12 is the continuous time sigma delta modulator of example 11, wherein the two sampled signals of the plurality of sampled signals are based on the same reference signal of the plurality of reference signals and are based on two oscillation signals of the plurality of oscillation signals exhibiting the same phase but different polarity.
Example 13 is the continuous time sigma delta modulator of any of examples 3 to 12, wherein the plurality of logic circuits are configured to generate a plurality of logic signals, and wherein the continuous time sigma delta modulator further comprises an output circuit configured to generate a digital output signal based on the plurality of logic signals.
Example 14 is the continuous time sigma delta modulator of example 13, wherein the output circuit comprises: a first first-in first-out memory circuit configured to store logic values of a first subset of the plurality of logic signals, wherein the logic signals of the first subset of the plurality of logic signals are based on respective pairs of the plurality of sampled signals that are based on a first pair of reference signals of the plurality of reference signals; and a second first-in first-out memory circuit configured to store logic values of a second subset of the plurality of logic signals, wherein the logic signals of the second subset of the plurality of logic signals are based on respective pairs of the plurality of sampled signals that are based on a second pair of reference signals of the plurality of reference signals.
Example 15 is the continuous time sigma delta modulator of example 14, wherein the first first-in first-out memory circuit is configured to store the logic values of the first subset of the plurality of logic signals based on a first clock signal, and wherein the second first-in first-out memory circuit is configured to store the logic values of the second subset of the plurality of logic signals based on a second clock signal.
Example 16 is the continuous time sigma delta modulator of example 15, wherein the first clock signal is on one of the first pair of reference signals, and wherein the second clock signal is on one of the second pair of reference signals.
Example 17 is the continuous time sigma delta modulator of any of examples 14 to 16, wherein the first first-in first-out memory circuit and the second first-in first-out memory circuit are configured to output the oldest memory value as digital output signal based on the same clock signal, respectively.
Example 18 is the continuous time sigma delta modulator of any of examples 1 to 17, wherein the plurality of reference signals are oscillation signals.
Example 19 is the continuous time sigma delta modulator of any of examples 1 to 18, wherein a frequency of the plurality of oscillation signals is equal to a frequency of the plurality of reference signals.
Example 20 is an analog-to-digital converter comprising a continuous time sigma delta modulator according to any of examples 1 to 19.
Example 21 is a method of operating a continuous time sigma delta modulator, comprising: generating, based on an analog oscillator control signal, a plurality of phase shifted oscillation signals using a ring oscillator; generating, using a plurality of sample circuits, a plurality of sampled signals by sampling each of the plurality of phase shifted oscillation signals based on each of a plurality of phase shifted reference signals; and generating, using a digital-to-analog converter, an analog feedback signal based on the plurality of sampled signals, wherein the oscillator control signal is based on the feedback signal.
Example 22 is the method of example 21, further comprising generating the oscillator control signal based on the feedback signal and an analog input signal using a loop filter coupled between the digital-to-analog converter and the ring oscillator.
Example 23 is the method of example 21 or example 22, further comprising generating at least one logic signal based on two sampled signals of the plurality of sampled signals using a plurality of logic circuits coupled between the plurality of sample circuits and the digital-to-analog converter, wherein generating the feedback signal comprises generating the feedback signal based on the least one logic signal.
Example 24 is the method of example 23, wherein generating the at least one logic signal is based on a logical XOR combination of the two sampled signals.
Example 25 is the method of example 23 or example 24, wherein the two sampled signals are based on the same oscillation signal of the plurality of oscillation signals and are based on different reference signals of the plurality of reference signals.
Example 26 is the method of example 25, wherein the different reference signals of the plurality of reference signals exhibit consecutive phases among the plurality of reference signals.
Example 27 is the method of any of examples 23 to 26, wherein generating the plurality of phase shifted oscillation signals comprises generating a first part of the plurality of oscillation signals with a first polarity and a second part of the plurality of oscillation signals with a second polarity, and wherein generating the feedback signal comprises generating the feedback signal with a first feedback signal component of the first polarity and a second feedback signal component of the second polarity.
Example 28 is the method of example 27, wherein the two sampled signals of the plurality of sampled signals are based on the same reference signal of the plurality of reference signals and are based on two oscillation signals of the plurality of oscillation signals exhibiting the same phase but different polarity.
Example 29 is the method of any of examples 23 to 28, further comprising: generating a plurality of logic signals using the plurality of logic circuits; and generating a digital output signal based on the plurality of logic signals using an output circuit.

The aspects and features mentioned and described together with one or more of the previously detailed examples and figures, may as well be combined with one or more of the other examples in order to replace a like feature of the other example or in order to additionally introduce the feature to the other example.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

Furthermore, the following claims are hereby incorporated into the detailed description, where each claim may stand on its own as a separate example. While each claim may stand on its own as a separate example, it is to be noted that - although a dependent claim may refer in the claims to a specific combination with one or more other claims - other examples may also include a combination of the dependent claim with the subject matter of each other dependent or independent claim. Such combinations are explicitly proposed herein unless it is stated that a specific combination is not intended. Furthermore, it is intended to include also features of a claim to any other independent claim even if this claim is not directly made dependent to the independent claim.

## Claims

1. A continuous time sigma delta modulator (100), comprising:
a ring oscillator (110) configured to generate, based on an analog oscillator control signal (101), a plurality of phase shifted oscillation signals (111);
a plurality of sample circuits (120) configured to generate a plurality of sampled signals (121) by sampling each of the plurality of oscillation signals (111) based on each of a plurality of phase shifted reference signals (103); and
a digital-to-analog converter (130) configured to generate an analog feedback signal (131) based on the plurality of sampled signals (121), wherein the oscillator control signal (101) is based on the feedback signal (131).

2. The continuous time sigma delta modulator of claim 1, further comprising:
a loop filter (140) coupled between the digital-to-analog converter (130) and the ring oscillator (110), wherein the loop filter (140) is configured to generate the oscillator control signal (101) based on the feedback signal (131) and an analog input signal (102).

3. The continuous time sigma delta modulator of claim 1 or claim 2, further comprising:
a plurality of logic circuits (170) coupled between the plurality of sample circuits (120) and the digital-to-analog converter (130), wherein at least one of the plurality of logic circuits (170) is configured to generate a logic signal (171_{I,J}) based on two sampled signals of the plurality of sampled signals (121),
wherein the digital-to-analog converter (130) is configured to generate the analog feedback (131) signal based on the logic signal (171_{I,J}).

4. The continuous time sigma delta modulator of claim 3, wherein the least one of the plurality of logic circuits (170) is configured to generate the logic signal (171_{I,J}) based on a logical XOR combination of the two sampled signals.

5. The continuous time sigma delta modulator of claim 3 or claim 4, wherein the two sampled signals are based on the same oscillation signal of the plurality of oscillation signals (111) and are based on different reference signals of the plurality of reference signals (103).

6. The continuous time sigma delta modulator of claim 5, wherein the different reference signals of the plurality of reference signals exhibit consecutive phases among the plurality of reference signals (103).

7. The continuous time sigma delta modulator of any of claims 3 to 6, wherein the plurality of logic circuits (170) are configured to generate a plurality of logic signals (171), and wherein the digital-to-analog converter (130) comprises:
a first digital-to-analog conversion circuit (132-1) configured to generate a first contribution (133-1) to the feedback signal (131) based on a first subset of the plurality of logic signals (171), wherein the logic signals of the first subset of the plurality of logic signals are based on sampled signals of the plurality of sampled signals (121) that are based on a first pair of reference signals of the plurality of reference signals (103);
a second digital-to-analog conversion circuit (132-2) configured to generate a second contribution (133-2) to the feedback signal (131) based on a second subset of the plurality of logic signals (171), wherein the logic signals of the second subset of the plurality of logic signals are based on sampled signals of the plurality of sampled signals (121) that are based on a second pair of reference signals of the plurality of reference signals (103);
a signal combiner (134) configured to generate the feedback signal (131) based on at least the first contribution (133-1) and the second contribution (133-2).

8. The continuous time sigma delta modulator of claim 7, wherein the first digital-to-analog conversion circuit (132-1) is clocked based on one of the first pair of reference signals, and wherein the second digital-to-analog conversion circuit (132-2) is clocked based on one of the second pair of reference signals.

9. The continuous time sigma delta modulator of claim 7 or claim 8, wherein the number of logic signals in the first subset of the plurality of logic signals (171) is equal to the number of the plurality of oscillation signals (111).

10. The continuous time sigma delta modulator of any of claims 7 to 9, wherein the digital-to-analog converter (131) comprises a number of digital-to-analog conversion circuits equal to the number of the plurality of reference signals (103).

11. The continuous time sigma delta modulator of any of claims 3 to 10, wherein the ring oscillator (110) is configured to generate a first part of the plurality of oscillation signals (111) with a first polarity and a second part of the plurality of oscillation signals (111) with a second polarity, and wherein the digital-to-analog converter (131) is configured to generate the feedback signal (131) with a first feedback signal component of the first polarity and a second feedback signal component of the second polarity.

12. The continuous time sigma delta modulator of claim 11, wherein the two sampled signals of the plurality of sampled signals (121) are based on the same reference signal of the plurality of reference signals (103) and are based on two oscillation signals of the plurality of oscillation signals (111) exhibiting the same phase but different polarity.

13. The continuous time sigma delta modulator of any of claims 3 to 12, wherein the plurality of logic circuits (170) are configured to generate a plurality of logic signals (171), and wherein the continuous time sigma delta modulator (100) further comprises:
an output circuit (150) configured to generate a digital output signal (151) based on the plurality of logic signals (171).

14. The continuous time sigma delta modulator of claim 13, wherein the output circuit (150) comprises:
a first first-in first-out memory circuit (152-1) configured to store logic values of a first subset of the plurality of logic signals (171), wherein the logic signals of the first subset of the plurality of logic signals (171) are based on respective pairs of the plurality of sampled signals (121) that are based on a first pair of reference signals of the plurality of reference signals (103); and
a second first-in first-out memory circuit (152-2) configured to store logic values of a second subset of the plurality of logic signals (171), wherein the logic signals of the second subset of the plurality of logic signals (171) are based on respective pairs of the plurality of sampled signals (121) that are based on a second pair of reference signals of the plurality of reference signals (103).

15. The continuous time sigma delta modulator of claim 14, wherein the first first-in first-out memory circuit (152-1) is configured to store the logic values of the first subset of the plurality of logic signals (171) based on a first clock signal, and wherein the second first-in first-out memory circuit (152-3) is configured to store the logic values of the second subset of the plurality of logic signals (171) based on a second clock signal.
